# EUROPEAN PATENT APPLICATION

(11) **EP 4 723 167 A1**
(43) Date of publication of application: **08.04.2026**
(21) Application number: 24814903.1
(22) Date of filing: 01.03.2024
(51) Int. Cl.: H01L 23/29, B29C 43/18, B29C 43/34, C08G 59/00, C08G 59/42, C08G 59/62

(54) **LIQUID COMPRESSION MOLDING MATERIAL, ELECTRONIC COMPONENT, AND SEMICONDUCTOR DEVICE**

(30) Priority: 29.05.2023 JP 2023087755
(71) Applicant: Namics Corporation, Niigata-shi, Niigata 950-3131 (JP)
(72) Inventor: TAKEBUCHI Masamichi, Niigata-shi, Niigata 950-3131 (JP); SAKAI Yosuke, Niigata-shi, Niigata 950-3131 (JP); SUZUKI Makoto, Niigata-shi, Niigata 950-3131 (JP); KAMIMURA Tsuyoshi, Niigata-shi, Niigata 950-3131 (JP)
(74) Representative: Mathys & Squire
(86) International application number: PCT/JP2024/007869
(87) International publication number: WO 2024/247416

(57) **Abstract**

To suppress warpage of a sealed article and to be excellent in fast curability. A liquid compression molding material containing a resin composition containing an epoxy resin (A), a phenolic curing agent (B1), an acid anhydride-based curing agent (B2), and an inorganic filler (C), in which a glass transition temperature Tg of a cured product of the resin composition is in a range of 50°C to 120°C.

## Description

### TECHNICAL FIELD

The present invention relates to a liquid compression molding material, and an electronic component and a semiconductor device manufactured using the liquid compression molding material.

### BACKGROUND ART

Most of semiconductor elements such as integrated circuits constituting the semiconductor device are sealed with a sealing material. Molding methods for sealing the semiconductor element can be broadly classified into (i) transfer molding in which a molten curable resin composition is pressure-injected and filled into a cavity through a flow path such as a runner or a gate that supplies a resin composition into the cavity, and then cured, and (ii) compression molding in which a granular or liquid curable resin composition is directly supplied onto a substrate or a release film and cured without passing through the flow path such as the runner or the gate. Then, among these molding methods, in recent years, the compression molding which is more suitable for manufacturing relatively large molded products has been increasingly employed as the molding method for sealing the semiconductor element. This is because, for example, a wafer-level chip size package (a package employing a processing process of sealing in a state of a wafer not divided into chips after completion of circuit formation) has become widespread as a packaging method for the semiconductor element. In addition, when sealing treatment of various elements such as the semiconductor element is performed using the sealing material, an organic substrate may be used as the substrate instead of a wafer made of an inorganic material such as silicon.

Conventional curable resin compositions used for sealing various elements such as semiconductor elements by compression molding were mainly solid resin compositions such as granular resin compositions. However, recently, with development of a new compression molding technology, a liquid curable resin composition (so-called liquid compression molding material) is often used. Hereinafter, the liquid compression molding material may be abbreviated as a "liquid compression molding (LCM) material".

In the compression molding using the LCM material, warpage of a sealed article (a member in which an element disposed on the substrate (the wafer or the organic substrate) is sealed with the sealing material (a cured product of the LCM material)) after the LCM material is cured and before dicing (before individualization) is a major problem. Since the LCM material contains a thermosetting resin, a heat treatment is performed in order to promote a curing reaction in a step of molding the LCM material. Then, in the subsequent cooling step, various elements such as the semiconductor element, the cured product (sealing material) of the LCM material, and the substrate (the wafer or the organic substrate) contract according to their respective thermal expansion coefficients, and thus dimensional changes of the respective members vary. As a result, the warpage occurs in the sealed article. In view of such circumstances, a technique related to the LCM material for the purpose of suppressing the warpage and the like has also been proposed (for example, PATENT LITERATURE 1).

### CITATION LIST

### PATENT LITERATURE

PATENT LITERATURE 1: JP-A-2006-232950

### SUMMARY OF INVENTION

### PROBLEMS TO BE SOLVED BY INVENTION

On the other hand, it is also important for the LCM material that a curing time is short (fast curability) from the viewpoint of productivity.

The present invention has been made in view of the above circumstances, and an object of the present invention is to provide a liquid compression molding material that suppresses the warpage of the sealed article and is also excellent in fast curability, and an electronic component and a semiconductor device manufactured using the liquid compression molding material.

### SOLUTION TO PROBLEMS

The above-described object is achieved by the following present invention. That is,
a liquid compression molding material according to a first aspect of the present invention includes a resin composition containing an epoxy resin (A), a phenolic curing agent (B1), an acid anhydride-based curing agent (B2), and an inorganic filler (C), and a glass transition temperature Tg of a cured product of the resin composition is in a range of 50°C to 120°C.

A liquid compression molding material according to a second aspect of the present invention includes a resin composition containing an epoxy resin (A), a phenolic curing agent (B1), an acid anhydride-based curing agent (B2), and an inorganic filler (C), and a content of the inorganic filler (C) in an entire resin composition is 55 mass% to 85 mass%.

In an embodiment of the liquid compression molding material according to the first and second aspects of the present invention, the phenolic curing agent (B1) preferably contains at least one selected from the group consisting of a phenol novolac resin, an alkylated product of the phenol novolac resin, an allylated product of the phenol novolac resin, a cresol novolac resin, a phenol aralkyl resin (provided that the resin includes a phenylene skeleton and/or a biphenylene skeleton), a naphthol aralkyl resin, a triphenol methane resin, and a dicyclopentadiene type phenol resin.

In another embodiment of the liquid compression molding material according to the first and second aspects of the present invention, the acid anhydride-based curing agent (B2) preferably contains at least one selected from the group consisting of phthalic anhydride, methylhymic anhydride, succinic anhydride substituted with an alkenyl group, methylnadic anhydride, and glutaric anhydride.

In another embodiment of the liquid compression molding material according to the first and second aspects of the present invention, a viscosity at room temperature (25°C) is preferably 10 Pa·s to 1000 Pa·s.

In another embodiment of the liquid compression molding material according to the first and second aspects of the present invention, a cured product obtained by heat-curing the resin composition at 180°C for 60 minutes preferably has an elastic modulus at 260°C in a range of 0.05 GPa to 0.5 GPa.

In another embodiment of the liquid compression molding material according to the first and second aspects of the present invention, b1:b2, which is a ratio of a phenol equivalent b1 of the phenolic curing agent (B1) to an acid anhydride equivalent b2 of the acid anhydride-based curing agent (B2), is preferably 10:90 to 90:10.

Another embodiment of the liquid compression molding material according to the first and second aspects of the present invention preferably further contains a curing accelerator (D).

An electronic component according to the present invention includes a sealing material including a cured product of the liquid compression molding material according to the first and second aspects of the present invention.

A semiconductor device according to the present invention includes: a substrate; a semiconductor element disposed on the substrate; and a cured product of the liquid compression molding material according to the first and second aspects of the present invention, the cured product sealing a gap between the semiconductor element and the substrate.

### EFFECTS OF INVENTION

According to the present invention, it is possible to provide a liquid compression molding material that suppresses the warpage of the sealed article and is also excellent in fast curability, and an electronic component and a semiconductor device manufactured using the liquid compression molding material.

### DESCRIPTION OF EMBODIMENTS

### <LCM material (First embodiment)>

An LCM material of a first embodiment includes a resin composition containing an epoxy resin (A), a phenolic curing agent (B1), an acid anhydride-based curing agent (B2), and an inorganic filler (C), and a glass transition temperature Tg of a cured product of the resin composition is in a range of 50°C to 120°C. Note that the glass transition temperature Tg is a temperature at which tanδ is a maximum value in a change curve of a loss tangent (tanδ) with respect to temperature measured by a dynamic mechanical analysis (DMA) method. Note that details of a measurement method will be described later.

In general, an elastic modulus of the cured product of the resin composition greatly changes with the glass transition temperature Tg as a boundary, and the cured product has a relatively extremely high elastic modulus in a temperature range in a glass state equal to or lower than the glass transition temperature Tg, and has a relatively extremely low elastic modulus in a temperature range in a rubber state exceeding the glass transition temperature Tg. On the other hand, in a compression molding process using the LCM material, a heating temperature at the time of molding and a heating temperature of post-curing performed after molding are usually higher than about 130°C. Therefore, in the LCM material of the first embodiment, the glass transition temperature Tg of the cured product is 120°C or lower. Thus, the elastic modulus of the cured product near the heating temperature at the time of molding or post-curing can be extremely lowered, so that internal stress generated due to a difference in degree of shrinkage of members constituting a sealed article in a cooling process after heating can be alleviated, and as a result, warpage of the sealed article can be suppressed. Note that the glass transition temperature Tg is preferably 110°C or lower, more preferably 100°C or lower, and still more preferably 90°C or lower from the viewpoint of suppressing the warpage and from the viewpoint of facilitating application of the LCM material of the first embodiment even when the heating temperature during molding and post-curing is lower than usual.

In the LCM material of the first embodiment, the phenolic curing agent (B1) and the acid anhydride-based curing agent (B2) are used in combination as curing agents (B). Here, the phenolic curing agent has an action of lowering the glass transition temperature Tg of the cured product as compared with a case of using only the acid anhydride-based curing agent as the curing agent. Therefore, as the curing agent (B), it is necessary to use the phenolic curing agent in order to control the glass transition temperature Tg of the cured product so as to obtain the elastic modulus of the cured product suitable for suppressing the warpage in heat treatment during molding and post-curing. However, since the phenolic curing agent has low reactivity, when only the phenolic curing agent is used as the curing agent, sufficient fast curability cannot be secured. Therefore, in the LCM material of the first embodiment, the acid anhydride-based curing agent having relatively higher reactivity than the phenolic curing agent is also used in combination. Thus, in the LCM material of the first embodiment, excellent fast curability can also be secured.

However, the acid anhydride-based curing agent has an action of raising the glass transition temperature Tg of the cured product. Therefore, in the LCM material of the first embodiment, the glass transition temperature Tg is 50°C or higher in consideration that the acid anhydride-based curing agent must also be used for securing excellent fast curability. Note that the glass transition temperature Tg is preferably 60°C or higher, and more preferably 71.5°C or higher. Here, as a suitable combination of an upper limit value and a lower limit value of the glass transition temperature Tg, any value selected from a plurality of types of upper limit values described above and any value selected from a plurality of types of lower limit values described above can be appropriately combined.

Note that, as apparent from the above description, the glass transition temperature Tg of the cured product can be controlled by appropriately selecting a ratio of a phenol equivalent b1 of the phenolic curing agent (B1) to an acid anhydride equivalent b2 of the acid anhydride-based curing agent (B2). In addition, the glass transition temperature Tg can also be controlled, for example, by appropriately selecting an epoxy equivalent of the epoxy resin (A), a degree of flexibility-rigidity of a molecular chain structure of the epoxy resin (A), or the like. As a specific example, when the epoxy equivalent is reduced, crosslinking density of the cured product can be increased, so that the glass transition temperature Tg can be raised, and when an epoxy resin having a highly rigid skeleton structure is used, the glass transition temperature Tg can be raised.

Next, details of various components used for the LCM material of the first embodiment, other physical property values other than the glass transition temperature Tg, and the like will be described.

### (A) Epoxy resin

The epoxy resin used for the LCM material of the first embodiment is not particularly limited as long as it is any of various epoxy resins generally used for semiconductor sealing. However, from the viewpoint of easily securing a viscosity suitable for the LCM material, it is preferable to use a liquid epoxy resin as the epoxy resin. Further, as the epoxy resin to be blended in the LCM material, only one type of epoxy resin may be used, or two or more types of epoxy resins may be used in combination.

Representative specific examples of the epoxy resin include an aromatic epoxy resin and an aliphatic epoxy resin. Examples of the aromatic epoxy resin include: bisphenol A type epoxy resins such as p-glycidyloxyphenyldimethyltrisbisphenol A diglycidyl ether; bisphenol F type epoxy resin; novolac type epoxy resin; fluorene type epoxy resin; biphenyl aralkyl epoxy resin; diepoxy resins such as p-tert-butyl phenyl glycidyl ether and 1,4-phenyldimethanol diglycidyl ether; biphenyl type epoxy resins such as 3,3',5,5'-tetramethyl-4,4'-diglycidyloxybiphenyl; aminophenol type epoxy resins such as diglycidyl aniline, diglycidyl toluidine, triglycidyl-p-aminophenol, and tetraglycidyl-m-xylylenediamine; naphthalene type epoxy resin; and epoxy resin having a plant-derived skeleton.

Examples of the aliphatic epoxy resin include: monofunctional aliphatic epoxy compounds having one epoxy group in the molecule, such as alkyl alcohol glycidyl ether [butyl glycidyl ether, 2-ethylhexyl glycidyl ether, and the like] and alkenyl alcohol glycidyl ether [vinyl glycidyl ether, allyl glycidyl ether, and the like]; bifunctional aliphatic epoxy compounds having two epoxy groups in the molecule, such as polyalkylene glycol diglycidyl ether such as alkylene glycol diglycidyl ether and polytetramethylene glycol diglycidyl ether, and alkenylene glycol diglycidyl ether; and polyfunctional aliphatic epoxy compounds having three or more epoxy groups in the molecule, such as polyglycidyl ethers [trimethylolpropane triglycidyl ether, pentaerythritol (tri or tetra) glycidyl ether, dipentaerythritol (tri, tetra, penta or hexa) glycidyl ether, and the like] of trifunctional or higher alcohols such as trimethylolpropane, pentaerythritol, and dipentaerythritol.

Among the various epoxy resins listed above, liquid bisphenol type epoxy, liquid naphthalene type epoxy, and liquid aminophenol type epoxy are preferable from the viewpoint of workability.

A content of the epoxy resin in an entire resin composition constituting the LCM material is preferably 5 mass% to 40 mass%, more preferably 5 mass% to 30 mass%, and still more preferably 8 mass% to 25 mass%.

### (B) Curing agent

In the LCM material of the first embodiment, the phenolic curing agent (B1) and the acid anhydride-based curing agent (B2) are used in combination as the curing agents (B). The phenolic curing agent and the acid anhydride-based curing agent can be used without particular limitation as long as they are known curing agents.

The phenolic curing agent has the action of lowering the glass transition temperature Tg of the cured product as compared with the acid anhydride-based curing agent. As the phenolic curing agent, any of monomers, oligomers, and polymers having a phenolic hydroxyl group can be used, and examples thereof include a phenol novolac resin, an alkylated product of the phenol novolac resin, an allylated product of the phenol novolac resin, a cresol novolac resin, a phenol aralkyl resin (provided that the resin includes a phenylene skeleton and/or a biphenylene skeleton), a naphthol aralkyl resin, a triphenol methane resin, and a dicyclopentadiene type phenol resin. As the phenolic curing agent to be blended in the resin composition constituting the LCM material, only one type of phenolic curing agent may be used, or two or more types of phenolic curing agents may be used in combination. Further, as the phenolic curing agent, from the viewpoint of workability, it is preferable to use a phenolic curing agent which is liquid at 25°C, and from the viewpoint of the action of lowering the glass transition temperature Tg of the cured product, a phenol novolac resin having little steric hindrance is particularly preferable.

The acid anhydride-based curing agent has an action of lowering viscosity of the resin composition constituting the LCM material and an action of raising the glass transition temperature Tg of the cured product. Examples of the acid anhydride-based curing agent include phthalic anhydride (for example, alkylated hydrophthalic anhydrides such as methyltetrahydrophthalic anhydride and methylhexahydrophthalic anhydride, and hexahydrophthalic anhydride), methylhymic anhydride, succinic anhydride substituted with an alkenyl group, methylnadic anhydride, and glutaric anhydride. As the acid anhydride-based curing agent to be blended in the resin composition constituting the LCM material, only one type of acid anhydride-based curing agent may be used, or two or more types of acid anhydride-based curing agents may be used in combination. Among these acid anhydride-based curing agents, methyltetrahydrophthalic anhydride and methylhexahydrophthalic anhydride are preferable because they are excellent in electrical insulation properties and heat resistance stability, and are liquid at normal temperature (25°C).

A blending ratio of the phenolic curing agent (B1) and the acid anhydride-based curing agent (B2) is not particularly limited, but the ratio of the phenol equivalent b1 of the phenolic curing agent (B1) to the acid anhydride equivalent b2 of the acid anhydride-based curing agent (B2), that is, an equivalent ratio b1:b2 is preferably 10:90 to 90:10, more preferably 15:85 to 85:15, still more preferably 35:65 to 80:20, and particularly preferably 50:50 to 80:20. Note that the phenol equivalent b1 is calculated from mass of a component (B1)/hydroxyl group equivalent in the component (B1), and the acid anhydride equivalent b2 is calculated from mass of a component (B2)/acid anhydride group equivalent in the component (B2).

When the equivalent ratio b1:b2 is set within the range of 10:90 to 90:10, it is easier to adjust the glass transition temperature Tg within the range of 50°C to 120°C and to secure excellent fast curability. In addition, it is also easy to lower the elastic modulus (high temperature elastic modulus) at 260°C. Note that a mass ratio of the phenolic curing agent (B1) and the acid anhydride-based curing agent (B2) is not particularly limited as long as the equivalent ratio b1:b2 can be adjusted within the range of 10:90 to 90:10, but the mass ratio is usually preferably 10:90 to 90:10, more preferably 15:85 to 85:15, and still more preferably 35:65 to 80:20.

A content of the curing agent (B) (that is, the phenolic curing agent (B1) and the acid anhydride-based curing agent (B2)) in the entire resin composition constituting the LCM material is preferably 2 mass% or more, more preferably 5 mass% or more, and still more preferably 8 mass% or more from the viewpoint of securing sufficient curability. On the other hand, an upper limit value of the content is not particularly limited, but is practically preferably 50 mass% or less, more preferably 30 mass% or less, and still more preferably 20 mass% or less from the viewpoint of blending balance with other components blended in the resin composition.

### (C) Inorganic filler

The inorganic filler is not particularly limited as long as it has an effect of reducing a linear expansion coefficient of the cured product of the resin composition constituting the LCM material. Examples of materials of the inorganic filler include silica, alumina, aluminum, aluminum nitride, silicon carbide, and silicon nitride. As the inorganic filler, silica or alumina is particularly suitable from the viewpoint of increasing a blending amount (filling amount) of the inorganic filler with respect to the resin composition. Further, the inorganic filler may be surface-treated with a surface treatment agent such as a silane coupling agent. Further, as the inorganic filler blended in the resin composition, only one type of inorganic filler may be used, or two or more types of inorganic fillers may be used in combination.

A shape of the inorganic filler is not particularly limited, and may be any form such as a spherical shape, an amorphous shape, or a flaky shape. In addition, an average particle diameter of the inorganic filler is preferably 0.001 µm to 10 µm, more preferably 0.005 µm to 7 µm, still more preferably 0.01 µm to 5 µm, and particularly preferably 0.03 µm to 3 µm. Note that the average particle diameter means a volume average particle diameter D50 (a particle diameter at which a cumulative value from a small diameter side of a volume-based particle size distribution is 50%) value measured using a laser diffraction particle size distribution measuring apparatus.

Note that from the viewpoint of further lowering the viscosity of the LCM material while maintaining a content of the inorganic filler blended in the LCM material high, it is preferable to use two types of inorganic fillers having different volume average particle diameters D50 in combination. In this case, a ratio (DL/DS) of a volume average particle diameter D50 (DL) of a large-diameter inorganic filler to a volume average particle diameter D50 (DS) of a small-diameter inorganic filler is preferably 4 to 30, and more preferably 8 to 15, and a ratio (AL/AS) of a content AL of the large-diameter inorganic filler to be blended in the LCM material to a content AS of the small-diameter inorganic filler to be blended in the LCM material is preferably 1 to 5, and more preferably 2 to 4.

The content of the inorganic filler in the entire resin composition constituting the LCM material is usually 90 mass% or less from a practical viewpoint of securing a handleable practical viscosity and facilitating preparation of the LCM material, and is preferably 85 mass% or less, more preferably 80 mass% or less, still more preferably 78.5 mass% or less, and particularly preferably 77 mass% or less from a viewpoint of securing a viscosity suitable for compression molding, and further is preferably 55 mass% or more, more preferably 61.5 mass% or more, still more preferably 65 mass% or more, even still more preferably 67 mass% or more, and particularly preferably 70 mass% or more from a viewpoint of further suppressing the warpage by reducing a thermal expansion coefficient of the cured product. Note that as a suitable combination of an upper limit value and a lower limit value of the content of the inorganic filler, any value selected from a plurality of kinds of upper limit values described above and any value selected from a plurality of kinds of lower limit values described above can be appropriately combined.

### Other components

In the LCM material of the first embodiment, other components other than the above components (A) to (C) may be further blended as necessary. The other components are not particularly limited, and examples thereof include a curing accelerator (D).

Specific examples of the curing accelerator (D) include imidazoles, salts of triphenylphosphine or tetraphenylphosphine, and modified imidazole compounds. Specific examples thereof include 2-methylimidazole, 2-ethylimidazole, 2-phenylimidazole, 2-phenyl-4-methylimidazole, 2-phenyl-4-methyl-5-hydroxymethylimidazole, 2-phenyl-4,5-dihydroxymethylimidazole, 2,4-diamino-6-(2'-methylimidazolyl-(1'))-ethyl-s-triazine isocyanuric acid adduct, epoxy-imidazole adduct-based compounds, and acrylate-imidazole adduct-based compounds. Further, as the curing accelerator to be blended in the resin composition constituting the LCM material, only one type may be used, or two or more types of curing accelerators may be used in combination. The curing accelerator is preferably an acrylate-imidazole adduct-based compound from the viewpoint of pot life.

A content of the curing accelerator (D) in the entire resin composition constituting the LCM material is preferably 0.1 mass% to 5.0 mass%, more preferably 0.3 mass% to 4.0 mass%, and still more preferably 0.5 mass% to 3.0 mass%.

Examples of other components that can be added as necessary in addition to the components (A) to (D) include a coupling agent, a pigment, an ion trapping agent, a leveling agent, an antioxidant, an antifoaming agent, a flame retardant, a colorant, a reactive diluent, an elastomer, and a mold release agent. A blending amount of these other components can be appropriately selected according to the type thereof. Of course, any one or more of the other components listed above may not be contained in the resin composition constituting the LCM material.

Next, suitable physical property values of the LCM material of the first embodiment and the cured product thereof will be described. For the cured product of the LCM material, the elastic modulus (high temperature elastic modulus) at 260°C measured by a DMA method is preferably 0.05 GPa to 0.50 GPa, more preferably 0.05 GPa to 0.40 GPa, still more preferably 0.05 GPa to 0.30 GPa, and particularly preferably 0.05 GPa to 0.20 GPa. By setting the high temperature elastic modulus within the above-mentioned numerical range, the sealing material (cured product of the LCM material) in a sealing component can be easily deformed following thermal expansion of a substrate or an element in contact with the sealing material during heat treatment in a high temperature range.

The linear expansion coefficient of the cured product of the LCM material in the temperature range equal to or lower than the glass transition temperature Tg is preferably 50 ppm/°C or less, and more preferably 40 ppm/°C or less. Note that from the viewpoint of suppressing the warpage of the sealed article, the linear expansion coefficient is preferably as small as possible, but since the cured product of the LCM material always contains a matrix that is easily thermally expanded (a matrix formed by the component (A), the component (B), and the like being cured) at a constant ratio, a lower limit value of the linear expansion coefficient is practically 10 ppm/°C or more. Note that when the linear expansion coefficient of the cured product of the LCM material has a relatively high value, usually, the warpage occurs and a degree thereof tends to be remarkable. However, even in such a case, since the cured product of the LCM material of the first embodiment has the glass transition temperature Tg of 120°C or lower as described above, it is extremely easy to suppress the warpage.

The viscosity of the LCM material of the first embodiment at 25°C is preferably 1000 Pa·s or less, more preferably 600 Pa·s or less, and still more preferably 300 Pa·s or less. Note that a lower limit value of the viscosity is not particularly limited, but is preferably 10 Pa·s or more in practical use. In addition, a resin composition for transfer molding is required to have high fluidity (low viscosity) in order to be injected under pressure into a cavity via a gate, a runner, or the like. However, in the LCM material used for compression molding, since it is not necessary to perform pressure injection when the LCM material is supplied into the cavity, it is sufficient to have appropriate fluidity. Taking this into consideration, the viscosity may be 110 Pa·s or more.

A gel time of the LCM material of the first embodiment is preferably 300 seconds or less, more preferably 250 seconds or less, and still more preferably 180 seconds or less from the viewpoint of fast curability when the LCM material is cured at 150°C. However, when the gel time is too short, there is a high possibility that the LCM material is hardened before molding after start of supply of the LCM material on the substrate or a release film by coating or the like, and thus a lower limit value of the gel time is practically preferably about 100 to 120 seconds or more although it depends on an operation speed of a compression molding apparatus to be actually used.

The LCM material of the first embodiment is prepared by mixing and stirring a mixture in which at least the components (A) to (C), which are essential components constituting the LCM material, are used, and other components other than the components (A) to (C) are added as necessary. For mixing and stirring, a known mixing and stirring means such as a roll mill or a planetary mixer can be appropriately used. When the epoxy resin (A) used for the preparation of the LCM material is solid, it is preferable that the epoxy resin is liquefied or fluidized by heating or the like and then mixed with remaining components. In addition, a procedure of mixing and stirring is not particularly limited, and for example, all the components constituting the LCM material may be mixed at the same time, and it is also possible to prepare a premix in which only some components are mixed first, and then further mix the remaining components into the premix. When it is difficult to uniformly disperse the inorganic filler (C) in the epoxy resin (A), a premix in which the epoxy resin (A) and the inorganic filler (C) are mixed first is prepared, and then the remaining components may be further mixed into the premix.

### <LCM material (Second embodiment)>

The LCM material of a second embodiment includes a resin composition containing an epoxy resin (A), a phenolic curing agent (B1), an acid anhydride-based curing agent (B2), and an inorganic filler (C), and a content of the inorganic filler (C) in the entire resin composition is 55 mass% to 85 mass%. When the content of the inorganic filler is 85 mass% or less, the warpage can be suppressed, and when the content is 55 mass% or more, excellent fast curability can be obtained. The upper limit value of the content of the inorganic filler is preferably 80 mass% or less, more preferably 78.5 mass% or less, and still more preferably 77 mass% or less, and the lower limit value is preferably 61.5 mass% or more, more preferably 65 mass% or more, still more preferably 67 mass% or more, and particularly preferably 70 mass% or more. Note that as the suitable combination of the upper limit value and the lower limit value of the content of the inorganic filler, any value selected from the plurality of kinds of upper limit values described above and any value selected from the plurality of kinds of lower limit values described above can be appropriately combined.

The glass transition temperature Tg of the cured product of the LCM material of the second embodiment is not particularly limited, but is preferably the same as that of the LCM material of the first embodiment. Furthermore, other matters other than the content of the inorganic filler and the glass transition temperature Tg can be the same as those of the LCM material of the first present embodiment.

### <Electronic component and semiconductor device>

The cured product of the LCM material of the first and second embodiments can be used as sealing materials constituting various electronic components. The electronic component of the present embodiment is not particularly limited in terms of material of the substrate or a type of element, as long as it includes a substrate such as a wafer or an organic substrate, various elements such as a semiconductor element disposed on the substrate, and a sealing material (a cured product of the LCM material of the first or second embodiment) for sealing a gap between the element and the substrate, but is particularly preferably a semiconductor device.

### EXAMPLES

Hereinafter, specific examples of the present invention will be described with reference to examples, but the present invention is not limited to only the examples described below.

### 1. Preparation of epoxy resin composition

LCM materials of Examples 1 to 23 and Comparative Examples 1 to 3 were prepared by mixing and stirring raw materials using a roll mill so as to have blending amounts shown in Tables 1 to 3. Note that details of each component used as a raw material are as follows. Further, the blending amount of each component shown in the tables is in parts by mass.

### 2. Raw material components used for preparing LCM material

### (A) Epoxy resin

- YDF-870GS (bisphenol F type epoxy resin: manufactured by NIPPON STEEL Chemical & Material CO., LTD.)
- HP-4032D (naphthalene type epoxy resin: manufactured by DIC Corporation)
- jER630LSD (aminophenol type epoxy resin: manufactured by Mitsubishi Chemical Corporation)
- YX7400 (liquid epoxy resin: manufactured by Mitsubishi Chemical Corporation)

### (B1) Phenolic curing agent

- MEH-8005 (liquid phenol novolac resin: manufactured by UBE Corporation, hydroxyl group equivalent: 135 g/eq)
- BRM-553 (solid phenol novolac resin: manufactured by Aica Kogyo Co., Ltd., hydroxyl group equivalent: 108 g/eq)

### (B2) Acid anhydride-based curing agent

- HN-5500 (methylhexahydrophthalic anhydride: manufactured by Resonac Corporation, acid anhydride group equivalent: 168 g/eq)
- HN-2200 (methyltetrahydrophthalic anhydride: manufactured by Resonac Corporation, acid anhydride group equivalent: 166 g/eq)
- MH-700 (mixture of 4-methylhexahydrophthalic anhydride and hexahydrophthalic anhydride: manufactured by New Japan Chemical Co., Ltd., acid anhydride group equivalent: 163 g/eq)

### (C) Inorganic filler

- SE2200-SME (methacrylic surface-treated silica filler, average particle diameter 0.5 µm, manufactured by Admatechs Co., Ltd.)
- YA050C-SM1 (methacrylic surface-treated silica filler, average particle diameter 0.05 µm, manufactured by Admatechs Co., Ltd.)
- FB7SDX (silica filler, average particle diameter: 7 µm, manufactured by Denka Company Limited)
- AG2051 SXM (phenylamino surface-treated alumina filler, average particle diameter 1 µm, manufactured by Admatechs Co., Ltd.)

### Other components

### (D) Curing accelerator

- HX-3088FR (core-shell type curing accelerator: manufactured by Asahi Kasei Corp.)
- 2MA-OK (curing accelerator: manufactured by Shikoku Chemicals Corporation) Coupling agent
- KBM-403 (silane coupling agent: manufactured by Shin-Etsu Chemical Co., Ltd.) Pigment
- Special Black 4 (pigment: manufactured by Orion Engineered Carbons)

### 3. Various measurement and evaluation methods

Hereinafter, i) a method for measuring the glass transition temperature Tg, a linear expansion coefficient CTE, and the high temperature elastic modulus of the cured product of the LCM material, ii) a method for measuring the viscosity of the LCM material, and iii) a method for evaluating warpage of a member produced by simulating the semiconductor device and the gel time of the LCM material will be described. Note that as for these measurement methods and evaluation methods, various measurement and evaluation conditions are set assuming a typical manufacturing process of the semiconductor device, in which the LCM material is applied onto the release film at normal temperature (25°C), then the release film is placed on a lower mold in a compression molding apparatus heated to 150°C, and molded (compression molding also serving as a preliminary curing treatment) together with a substrate placed on the upper mold at 150°C, followed by post-curing (main hardening treatment) at 180°C for 60 minutes, and then reflow at 260°C.

### (Glass transition temperature Tg)

The glass transition temperature Tg of the LCM material was measured by a dynamic mechanical analysis (DMA) method using DMS6100 of Seiko Instruments Inc. (SII) for a cured product obtained by heat-curing the LCM material at 180°C for 60 minutes. Note that the glass transition temperature Tg is the temperature at which the tanδ is the maximum value in the change curve of the loss tangent (tanδ) with respect to the temperature measured by the DMA method. The tanδ is calculated by dividing a loss modulus at an arbitrary temperature by a storage modulus at that temperature.

### (Linear expansion coefficient CTE)

The linear expansion coefficient CTE of the LCM material was measured by a thermomechanical analysis (TMA) method using TMA4000SA of Bruker Corporation for a measurement sample obtained by processing a cured product obtained by heat-curing the LCM material at 180°C for 60 minutes into a predetermined shape. On the basis of a length of the measurement sample at 30°C and the length of the measurement sample at 50°C, a slope in a section of 30°C to 50°C was determined, and this slope was determined as the linear expansion coefficient CTE.

### (High temperature elastic modulus)

The high temperature elastic modulus of the LCM material was measured by the dynamic mechanical analysis (DMA) method using DMS6100 of SII for the cured product obtained by heat-curing the LCM material at 180°C for 60 minutes. At this time, the storage modulus at 260°C was determined as the high temperature elastic modulus.

### (Viscosity)

The viscosity of the LCM material was measured at 25°C using a B-type viscometer (DV-1 manufactured by Brookfield) at a rotation speed of 20 rpm.

### (Warpage)

The warpage was evaluated by the following procedure. First, the upper and lower molds in the compression molding apparatus were heated to 150°C, and then an FR4 substrate (GN74240: manufactured by Global Net Corp.) of 74 mm in length, 240 mm in width, and 300 µm in thickness was placed on the upper mold. Next, the LCM material was applied onto the release film, and the release film was placed on the lower mold in the compression molding apparatus with a surface to which the LCM material was applied facing upward. Thereafter, the lower mold was operated to perform compression molding at 150°C for 300 seconds. A size of the cured product formed on the FR4 substrate was 67 mm in length, 233 mm in width, and 250 µm in thickness. After completion of the compression molding, the FR4 substrate on which the cured product was formed was removed from the mold and put in a dryer set at 180°C for 1 hour. As described above, an evaluation sample in which a layer including the cured product of the LCM material was formed on one surface of the FR4 substrate was prepared. Next, this evaluation sample was placed on a horizontal table so that a surface on which a cured product layer was formed was an upper surface. In this state, a distance from a lower surface of the evaluation sample to the table was measured. Note that the measurement was performed at four corners of the evaluation sample, and a maximum value among measured values at the four corners was taken as a value of the warpage.

### (Gel time)

The gel time of the LCM material was measured under measurement conditions of a rotation speed of 120 rpm, a test temperature of 150°C, and a sample amount of 0.3 ml using an automatic curing time measuring apparatus "Madoka" manufactured by Matsuo Sangyo Co., Ltd. The smaller the gel time is, the more excellent the fast curability is. However, when the gel time is too short, there is a high possibility that the LCM material is hardened before molding after the start of the supply of the LCM material on the substrate or the release film by coating or the like, and thus the lower limit value of the gel time is practically about 100 seconds to 120 seconds or more although it depends on the operation speed of the compression molding apparatus to be actually used.

### 4. Evaluation results

Tables 1 to 3 show various measurement and evaluation results together with blending composition of the LCM materials of Examples and Comparative Examples.

**[Table 1]**

| | | | Example 1 | Example 2 | Example 3 | Example 4 | Example 5 | Example 6 | Example 7 | Example 8 | Example 9 | Example 10 |
|---|---|---|---|---|---|---|---|---|---|---|---|---|
| (A) Epoxy resin | Bisphenol F type epoxy | YDF-870GS | 12.84 | 12.97 | 13.30 | 13.45 | 13.64 | 13.83 | 10.20 | 11.75 | 15.38 | 20.53 |
| | Naphthalene type epoxy | HP-4032D | | | | | | | | | | |
| | Aminophenol type epoxy | iER630LSD | | | | | | | | | | |
| | Liquid epoxy resin | YX7400 | | | | | | | | | | |
| (B1) Phenolic curing agent | Liquid phenol novolac resin | MEH-8005 | 1.45 | 2.43 | 4.98 | 6.03 | 7.66 | 8.74 | 3.82 | 4.40 | 5.76 | 7.70 |
| | Phenol novolac resin | BRM-553 | | | | | | | | | | |
| (B2) Acid anhydride-based curing agent | Methylhexahydrophthalic anhydride | HN-5500 | 10.19 | 9.08 | 6.20 | 5.00 | 3.18 | 1.91 | 4.75 | 5.47 | 7.16 | 9.58 |
| | Methyltetrahydrophthalic anhydride | HN-2200 | | | | | | | | | | |
| (C) Inorganic filler | Surface-treated silica filler | SE2200-SME | 54.54 | 54.54 | 54.54 | 54.54 | 54.54 | 54.54 | 58.96 | 56.75 | 51.59 | 44.22 |
| | Surface-treated nanosilica filler | YA050C-SM1 | 19.46 | 19.46 | 19.46 | 19.46 | 19.46 | 19.46 | 21.04 | 20.25 | 18.41 | 15.78 |
| | Silica filler | FB7SDX | | | | | | | | | | |
| | Surface-treated alumina filler | AG2051 SXM | | | | | | | | | | |
| (D) Curing accelerator | Core-shell type curing accelerator | HX-3088FR | 0.97 | 0.97 | 0.97 | 0.97 | 0.97 | 0.97 | 0.74 | 0.85 | 1.11 | 1.49 |
| | Curing accelerator | 2MA-OK | | | | | | | | | | |
| Additive | Silane coupling agent | KBM-403 | 0.23 | 0.23 | 0.23 | 0.23 | 0.23 | 0.23 | 0.24 | 0.24 | 0.22 | 0.19 |
| | Pigment | Special Black 4 | 0.32 | 0.32 | 0.32 | 0.32 | 0.32 | 0.32 | 0.25 | 0.29 | 0.37 | 0.51 |
| Total (parts by mass) | | | 100.00 | 100.00 | 100.00 | 100.00 | 100.00 | 100.00 | 100.00 | 100.00 | 100.00 | 100.00 |
| Equivalent ratio b1:b2 (*1) | | | 15:85 | 25:75 | 50:50 | 60:40 | 75:25 | 85:15 | 50:50 | 50:50 | 50:50 | 50:50 |
| Content of inorganic filler (mass%) | | | 74.00 | 74.00 | 74.00 | 74.00 | 74.00 | 74.00 | 80.00 | 77.00 | 70.00 | 60.00 |
| Evaluation results | Viscosity [Pa·s] | | 33 | 41 | 77 | 114 | 172 | 197 | 498 | 162 | 47 | 19 |
| | Glass transition temperature Tg [°C] | | 112 | 105 | 90 | 85 | 75 | 73 | 86 | 87 | 91 | 94 |
| | High temperature elastic modulus [GPa] | | 0.36 | 0.27 | 0.20 | 0.19 | 0.09 | 0.10 | 0.28 | 0.25 | 0.18 | 0.11 |
| | Linear expansion coefficient CTE [ppm/°C] | | 20.4 | 20.5 | 21.4 | 21.8 | 22.8 | 23.0 | 20.5 | 19.3 | 22.3 | 33.1 |
| | Warpage amount [mm] | | 53 | 42 | 35 | 30 | 29 | 28 | 50 | 42 | 35 | 47 |
| | Gel time [sec] | | 124 | 133 | 149 | 170 | 246 | 285 | 138 | 146 | 172 | 214 |

*1 Ratio of phenol equivalent b1 of component (B1) and acid anhydride equivalent b2 of component (B2)

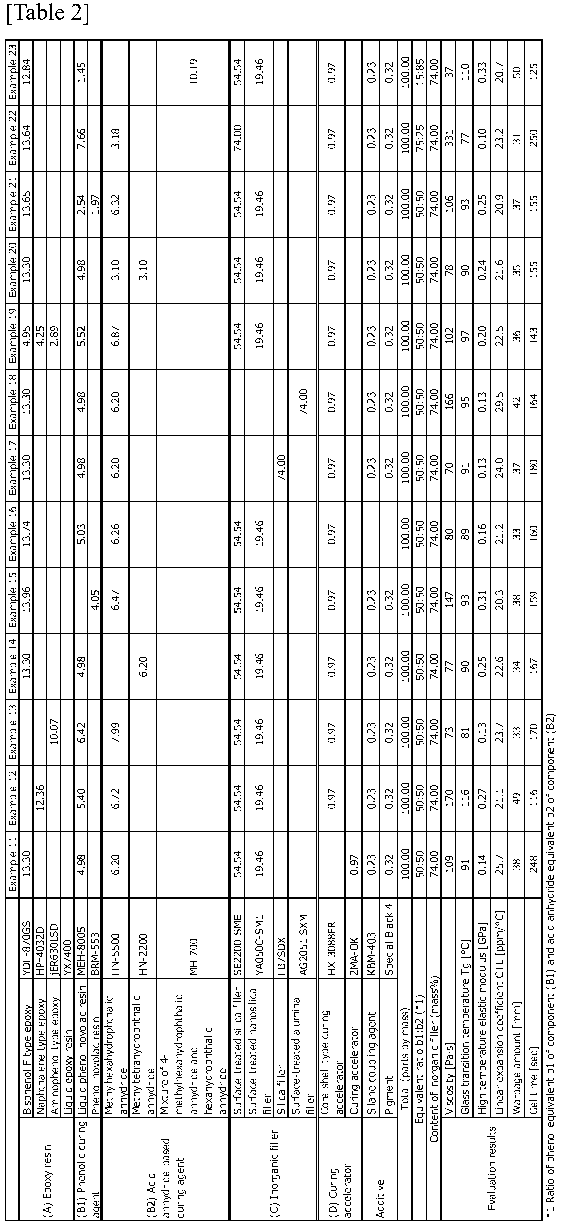

**[Table 3]**

| | | | Comparative Example 1 | Comparative Example 2 | Comparative Example 3 |
|---|---|---|---|---|---|
| (A) Epoxy resin | Bisphenol F type epoxy | YDF-870GS | 12.66 | 14.00 | 18.59 |
| | Naphthalene type epoxy | HP-4032D | | | |
| | Aminophenol type epoxy | jER630LSD | | | |
| | Liquid epoxy resin | YX7400 | | | 11.40 |
| (B1) Phenolic curing agent | Liquid phenol novolac resin | MEH-8005 | | 10.48 | 17.15 |
| | Phenol novolac resin | BRM-553 | | | |
| (B2) Acid anhydride-based curing agent | Methylhexahydrophthalic anhydride | HN-5500 | 11.82 | | 0.21 |
| | Methyltetrahydrophthalic anhydride | HN-2200 | | | |
| (C) Inorganic filler | Surface-treated silica filler | SE2200-SME | 54.54 | 54.54 | 36.85 |
| | Surface-treated nanosilica filler | YA050C-SM1 | 19.46 | 19.46 | 13.15 |
| | Silica filler | FB7SDX | | | |
| | Surface-treated alumina filler | AG2051 SXM | | | |
| (D) Curing accelerator | Core-shell type curing accelerator | HX-3088FR | 0.97 | 0.97 | 1.87 |
| | Curing accelerator | 2MA-OK | | | |
| Additive | Silane coupling agent | KBM-403 | 0.23 | 0.23 | 0.18 |
| | Pigment | Special Black 4 | 0.32 | 0.32 | 0.60 |
| Total (parts by mass) | | | 100.00 | 100.00 | 100.00 |
| Equivalent ratio b1:b2 (*1) | | | 0:100 | 100:0 | 99:1 |
| Content of inorganic filler (mass%) | | | 74.00 | 74.00 | 50.00 |
| Evaluation results | Viscosity [Pa·s] | | 26 | 225 | 143 |
| | Glass transition temperature Tg [°C] | | 130 | 70 | 37 |
| | High temperature elastic modulus [GPa] | | 0.55 | 0.147 | 0.02 |
| | Linear expansion coefficient CTE [ppm/°C] | | 21.3 | 27.3 | not evaluated |
| | Warpage amount [mm] | | 60 | 31 | not evaluated |
| | Gel time [sec] | | 119 | 362 | 603 |

| | | | | | |
|---|---|---|---|---|---|
| *1 Ratio or phenol equivalent b1 of component (B1) and acid anhydride equivalent b2 of component (B2) | | | | | |

## Claims

1. A liquid compression molding material comprising a resin composition containing
an epoxy resin (A),
a phenolic curing agent (B1),
an acid anhydride-based curing agent (B2), and
an inorganic filler (C), wherein
a glass transition temperature Tg of a cured product of the resin composition is in a range of 50°C to 120°C.

2. A liquid compression molding material comprising a resin composition containing
an epoxy resin (A),
a phenolic curing agent (B1),
an acid anhydride-based curing agent (B2), and
an inorganic filler (C), wherein
a content of the inorganic filler (C) in an entire resin composition is 55 mass% to 85 mass%.

3. The liquid compression molding material according to claim 1 or 2, wherein the phenolic curing agent (B1) contains at least one selected from the group consisting of a phenol novolac resin, an alkylated product of the phenol novolac resin, an allylated product of the phenol novolac resin, a cresol novolac resin, a phenol aralkyl resin (provided that the resin includes a phenylene skeleton and/or a biphenylene skeleton), a naphthol aralkyl resin, a triphenol methane resin, and a dicyclopentadiene type phenol resin.

4. The liquid compression molding material according to any one of claims 1 to 3, wherein the acid anhydride-based curing agent (B2) contains at least one selected from the group consisting of phthalic anhydride, methylhymic anhydride, succinic anhydride substituted with an alkenyl group, methylnadic anhydride, and glutaric anhydride.

5. The liquid compression molding material according to any one of claims 1 to 4, wherein a viscosity at room temperature (25°C) is 10 Pa·s to 1000 Pa·s.

6. The liquid compression molding material according to any one of claims 1 to 5, wherein a cured product obtained by heat-curing the resin composition at 180°C for 60 minutes has an elastic modulus at 260°C in a range of 0.05 GPa to 0.5 GPa.

7. The liquid compression molding material according to any one of claims 1 to 6, wherein b1:b2, which is a ratio of a phenol equivalent b1 of the phenolic curing agent (B1) to an acid anhydride equivalent b2 of the acid anhydride-based curing agent (B2), is 10:90 to 90:10.

8. The liquid compression molding material according to any one of claims 1 to 7, further comprising a curing accelerator (D).

9. An electronic component comprising a sealing material containing a cured product of the liquid compression molding material according to any one of claims 1 to 8.

10. A semiconductor device comprising:
a substrate;
a semiconductor element disposed on the substrate; and
a cured product of the liquid compression molding material according to any one of claims 1 to 8, the cured product sealing a gap between the semiconductor element and the substrate.
